# EUROPEAN PATENT SPECIFICATION

(11) **EP 3 499 520 B1**
(45) Date of publication and mention of the grant of the patent: **03.06.2020**
(21) Application number: 17207432.0
(22) Date of filing: 14.12.2017
(51) Int. Cl.: H01F 3/02, H01F 3/04, H01F 38/28, H01F 38/30, H01F 27/34

(54) **MAGNETIC CORE HAVING A CONTACT INSERTION HOLE WITH HOLDING FLAPS**
MAGNETKERN MIT EINER KONTAKTEINSTECKÖFFNUNG MIT HALTELASCHEN
NOYAU MAGNÉTIQUE AYANT UN TROU D'INSERTION DE CONTACT COMPORTANT DES RABATS DE RETENUE

(43) Date of publication of application: 19.06.2019
(73) Proprietor: TE Connectivity Germany GmbH, 64625 Bensheim (DE)
(72) Inventor: Kraemer, Christoph, 77963 Schwanau (DE); Schulz, Alexander, 67459 Boehl-Iggelheim (DE); Rajula, Gangi Reddy, 69115 Heidelberg (DE); Pichler, Michael, 76776 Neuburg (DE)
(74) Representative: Grünecker Patent- und Rechtsanwälte PartG mbB

(56) References cited:
- EP-B1- 2 073 025
- JP-A- 2011 035 083
- JP-A- 2014 066 691
- US-A- 6 005 383

## Description

The invention relates to a magnetic core, which for example is used in current sensors, in particular open loop current sensors.

Inside such magnetic cores, currents may be introduced if high-frequency current loads are measured. Further, the magnetic core may act as a capacity in this instance, introducing energy losses which impair accuracy of the measurement. These eddy currents lead to energy losses which impair the frequency response of the measurement. Further, there exists the parasitic capacitances between the current carrying conductor, magnetic core and sensing element. The switching voltages on the current carrying conductor results in disturbances on the sensor output signal. Connecting the magnetic core to the ground reduces the disturbance on the sensor signal output significantly. It is therefore known, e.g. from JP 2011-35083 A and EP 2 073 025 B1 to shortcut these eddy currents by inserting a pin into the magnetic core and connecting the pin with a ground potential. The magnetic core can no longer act as a capacity.

In the above-referenced prior art documents, the magnetic core comprises a contact insertion hole as a female connector, into which the pin is inserted as a plug contact or male connector. For this type of connection, a minimum contact normal force has to be guaranteed over the lifetime of the magnetic core. The contact normal force determines the force by which the plug contact is retained in the contact insertion hole.

JP 2014 066691 A1 discloses an electric current sensor that having a core grounding structure. The electric current sensor has an annular-shaped magnetic core body comprising a gap with a magneto-electric conversion element arranged in said gap. A core grounding member formed of metal wires is press fitted into a hole for connecting the core grounding member to the magnetic core body.

It is the object of the invention to provide a magnetic core which allows to be shortcut by insertion of a plug contact and which guarantees a minimum contact normal force over a lifetime. According to the invention, this object is achieved by a magnetic core for conducting a magnetic field, the magnetic core having at least one contact insertion hole for inserting a plug contact, which penetrates the core at least partially, the contact insertion hole extending in an insertion direction into the core and comprising at least two holding flaps which are stacked with respect to the insertion direction and extend substantially perpendicular to the insertion direction of the plug contact.

The holding flaps allow to secure the plug contact in the contact insertion hole. Each holding flap acts like a lamella which is bent by the insertion of the plug contact. The bent flap works like a leaf spring and thus ensures the required contact normal force. The normal force can easily be adjusted to the specific requirements by changing the length and/or thickness of the flap.

The invention can be further improved by at least one of the following features, which can be added independently of one another, to the above magnetic core.

For example, the magnetic core may comprise a plurality of layers of magnetic sheet material, wherein the contact insertion hole penetrates at least some of the layers, and wherein each of the at least two holding flaps is part of, and/or formed by a different layer. This design ensures that each layer contacts the plug contact once it has been inserted into the contact insertion hole.

The material thickness of a holding flap in the insertion direction may correspond to the material thickness of the layer which forms the respective holding flap. Thus, the holding flap can be manufactured simply by shaping the respective layers of sheet material before they are stacked to form the magnetic core. In particular, the plurality of layers and/or holding flaps may have the same material thickness.

To reduce eddy currents, each layer may be covered by an electric insulating material such as an insulating varnish. To simplify the manufacturing process, the insulating material may also cover the holding flaps. Thus, no special precaution needs to be taken to keep the holding flaps clear of the insulating layer. By selecting an appropriate contact normal force, the insulating material may be scraped off automatically upon insertion of the plug contact into the contact insertion hole and elastic deflection of the holding flaps.

To avoid holding flaps that are too stiff and do not bend, it is preferred that the length of a flap in a direction perpendicular to the insertion direction is at least half a flap and/or layer thickness. If, on the other hand, the holding flap is too long, a tight positioning of the plug contact within the contact insertion hole may be difficult, especially if strong lateral forces act on the inserted plug contact in a direction perpendicular to the insertion direction. For this purpose, it is of advantage if the length of a holding flap, preferably of all holding flaps, is less than 5 thicknesses of the holding flap and/or the layer forming the holding flap.

According to another advantageous embodiment, at least one, preferably exactly one layer may be arranged between two successive flaps in the insertion direction. For example, if two holding flaps overlap each other in the insertion direction so that one holding flap is arranged directly beneath the other holding flap, there may be at least one or exactly one layer between these two holding flaps. The arrangement provides room for the holding flaps to be bent upon insertion of the plug contact without successive holding flaps interfering with each other.

It may be preferred that there is more than one contact insertion hole provided in the magnetic core and that each layer forms a flap of at least one insertion hole. Thus, it can be ensured that each layer contacts at least one plug contact. In such a design, it is not necessary anymore to additionally connect the layers with each other such as by welding. If, in another embodiment, the plug contact is not electrically connected to all ferromagnetic layers, it is preferred that all layers are electrically connected to one another by an additional feature such as a welded line which may be placed across the layers on a side of the core, or by a stacking and compacting feature such as a punch which causes all layers to be electrically connected. Such a feature has thus both a mechanical effect, namely to hold the stack together, and an electric effect, namely to connect all layers.

To allow self-centering of a plug contact within the contact insertion hole, at least two holding flaps may be comprised that are arranged opposite each other in a direction perpendicular to the insertion direction, preferably symmetric to the centerline of the insertion hole.

Preferably, the opposing flaps have equal length or even equal geometry to ensure symmetric distribution of the contact normal force generated by each holding flap. If a non-circular plug contact is used, such as a tab which has for example an oblong, rectangular cross section, or a pin with a quadratic cross section, at least one pair of opposing flaps may be used. For a plug contact having a circular cross section, more than two opposing flaps, which are preferably equigonally distributed around the perimeter of the contact insertion hole, may be used.

The at least two holding flaps that are arranged opposite each other may be formed by the same layer of the magnetic core so that the contact normal force of each set of opposing holding flaps is exerted in a single plane. This helps to keep the plug contact centered in the contact insertion hole.

To allow for sufficient space once the holding flaps are bent and to exclude any interference or contact between the holding flaps once the plug contact is inserted, it is preferred that opposed holding flaps are spaced apart from each other in a direction perpendicular to the insertion direction. To facilitate a self-centering insertion of the plug contact into the contact insertion hole, the spaces between stacked opposing flaps may be aligned with a centerline of the contact insertion hole, the centerline being parallel to the insertion direction.

Moreover, the spaces between stacked opposing flaps may be aligned to form a straight continuous opening. Such a straight continuous opening may guide a tip of the plug contact while it is inserted.

According to another preferred embodiment, the at least two flaps may be arranged at a distance from an entry and/or exit opening of the contact insertion hole. The entry opening is the opening which is located against the insertion direction, i.e. the opening through which the plug contact is inserted into the contact insertion hole. The distance between the entry and/or exit opening and the closest flap or flaps in the insertion direction can be used to more snugly fit the plug contact into the insertion hole by providing the plug contact with a collar or other centering portion which is formed complementary to the flap-free section adjacent to the opening of the contact insertion hole.

If the contact insertion hole is a through hole, the flaps may be spaced along the insertion direction from both openings.

The magnetic core may have at least one of a C-shape, a U-shape and a ring shape, the ring shape being circumferentially closed except for a magnetic air gap.

The invention further relates to an assembly which comprises a magnetic core according to any combination of the above features and a plug contact for insertion into the contact insertion hole.

In order to guarantee a minimum contact normal force, a plastic deformation of the plug contact due to the insertion, in particular due to the holding flaps pressing against the plug contact, should be avoided. Therefore, it is provided according to another embodiment of the invention that the plug contact comprises a first electrically conductive material in a region for insertion into the contact insertion hole and a second electrically conductive material. The first electrically conductive material forms an outer surface of the plug contact and has a higher hardness than the second electrically conductive material. Therefore, integrity of the plug contact is ensured.

Another improvement is concerned with ensuring a lifelong minimum contact normal force by avoiding corrosion between the holding flaps and the plug contact once the latter is inserted into the contact insertion hole. To achieve this objective, the first electrically conductive material may have an electric potential which is closer to the electric potential of the material of at least one, preferably some or all, of the holding flaps than the electric potential of the second electrically conductive material. The two features of selecting the hardness and selecting the electric potential of the first electrically conductive material are independent of one another.

In particular, the first electrically conductive material may be steel. The first electrically conductive material may form a layer on the second electrically conductive material. The first electrically conductive material may be formed by punch plating or electric coating. The first electrically conductive material may in particular be steel.

An assembly, e.g. for a current sensor, may comprise a magnetic core and a plug contact in one of the above configurations.

The assembly may further comprise a magnetic air gap which is formed by the magnetic core, wherein a magnetic sensor, such as a hall sensor, may be arranged in the magnetic air gap.

The assembly may comprise at least one plug contact which is inserted into at least one contact insertion hole, wherein at least one holding flap comprises a free end, and wherein the free end is pressed against a surface of the plug contact. To increase the pressure, the free end may comprise an edge which is pressed against the plug contact if the latter is inserted into the contact insertion hole. In particular, the at least one holding flap comprising the edge may be elastically bent in the insertion direction by the plug contact. By pressing the edge against a surface of the plug contact, a high surface pressure is generated. The high surface pressure ensures a tight contact, thus low contact resistance and a good electric connection. At the same time, the high surface pressure allows removal of any oxidized surface layer on at least one of the plug contacts and the holding flaps, as well as any insulation layer.

The plug contact may, in another embodiment, be provided with a positioning collar, which is located in the flap-free entry region of the contact insertion hole. The flap-free entry region is preferably immediately adjacent to the opening of the contact insertion hole situated against the insertion direction. The positioning collar may have a cross section which is complementary to the cross section of the entry region. The collar surface may be made from the first electrically conductive material.

In the following, the invention is exemplarily described in greater detail with reference to the accompanying drawings. In the drawings, the same reference numerals are used for elements that correspond to each other in at least one of function and/or design.

It is clear from the above description that the combination of features of the described embodiments may be altered. For example, a feature of an embodiment may be omitted if the technical effect of this particular feature is not needed for a specific application. In turn, a feature may be added to the described embodiment if the technical effect of this feature is of advantage or needed for a specific application.

In the drawings,
- Fig. 1: shows a schematic perspective view of a current sensor in which a magnetic core according to the invention is used;
- Fig. 2: shows a schematic cut view of a magnetic core according to the invention together with a plug contact;
- Fig. 3: shows a schematic plan view along the arrows III in Fig. 2;
- Fig. 4: shows a schematic cut view of the plug contact inserted into the magnetic core of Fig. 2;
- Fig. 5: shows a schematic plan view of another magnetic core according to the invention;
- Fig. 6: shows a schematic cut view of another magnetic core according to the invention;
- Fig. 7: shows the schematic cut view of another magnetic core according to the invention; and
- Fig. 8: shows a schematic perspective view of a plug contact according to the invention.

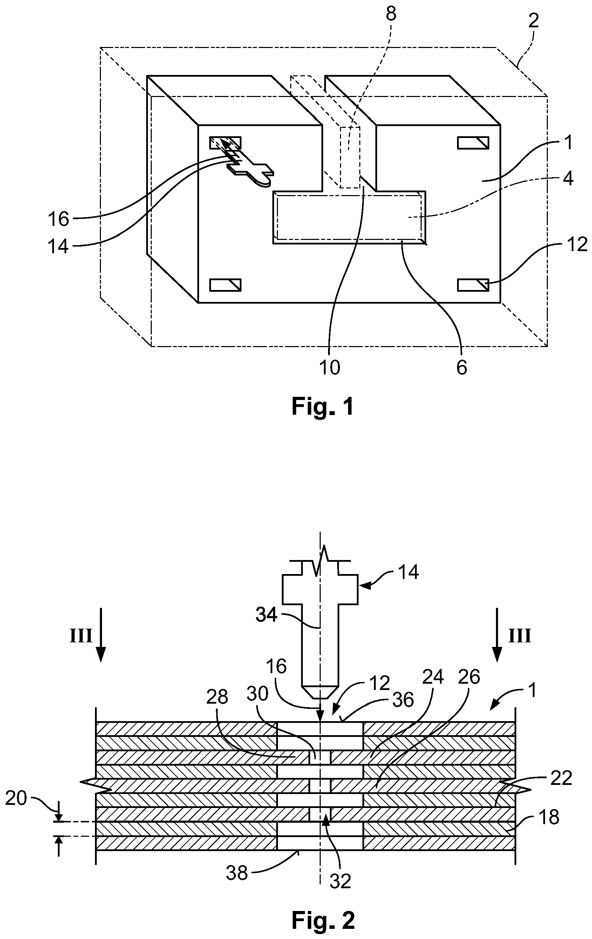

First, the general design of a magnetic core 1 according to the invention is described exemplarily with reference to Fig. 1. The magnetic core 1 may be part of a current sensor 2 which is used to measure an electric current flowing through an electric conductor 4.

The magnetic core 1 has a central opening 6, in which the electric conductor 4 may be arranged. The magnetic core 1 conducts a magnetic field (not shown) which is generated by and surrounds the electric conductor 4 when a current is flowing therethrough. The magnetic field is conducted by the magnetic core 1 to a magnetic sensor 8, which may comprise a hall sensor and an integrated circuit, and is only schematically depicted in Fig. 1. The magnetic sensor 8 may be arranged in a magnetic air gap 10 which is formed by the magnetic core 1. The magnetic core 1 may thus have a ring shape, which, except for the magnetic air gap 10, is closed circumferentially. In Fig. 1, the ring shape is polygonal, in particular, rectangular. However, the ring shape may also be round, e.g. circular. Other shapes such as a U-shape or a C-shape are also possible for the magnetic core 1, especially if the magnetic core 1 is used in applications other than current sensing.

In order to prevent the generation of such losses and reactive currents, at least one contact insertion hole 12 is provided into which a plug contact 14 may be inserted in an insertion direction 16. The plug contact 14 may be connected to a ground potential so that switching voltage disturbances on the current sensor output will collapse.

The magnetic core 1 in Fig. 1 is only exemplarily shown as having four contact insertion holes 12, which may be located in the corners. At least one contact insertion hole 12 may be provided, its location not being restricted to the corners or any other location of the core.

As shown in Fig. 2, the magnetic core 1 may comprise a plurality of layers 18 that are stacked above each other in the insertion direction 16. Alternatively, the insertion direction 16 may also be inclined with respect to the direction in which the layers 18 are stacked above each other. The layers 18 may have the same or varying material thickness 20. Each layer 18 may be separated from at least one of its adjacent layers by an electric insulation layer, such as an insulation varnish. The magnetic core 1 is preferably made from a soft iron or ferromagnetic material.

The alternating magnetic field creates eddy currents in the core. In order to suppress the eddy currents caused by the alternating magnetic field, the core consists of many insulated ferromagnetic layers. The insulated layers themselves cause side effects like forming inter layer capacitances. Any switching voltages on the conductor 4 results in disturbances on the current sensor output signals, in particular, if high-frequency currents have to be measured. This creates reactive out-of-phase currents and losses that impair accuracy of current sensing.

The contact insertion hole 12 comprises at least two holding flaps 24, 26 which are stacked in the insertion direction 16, i.e. one holding flap 26 is located behind the other holding flap 24 with respect to the insertion direction 16. Both flaps 24, 26 overlap in the insertion direction 16. Each holding flap 24, 26 extends substantially perpendicular to the insertion direction 16.

As shown in Fig. 2, at least one holding flap 24 may have an opposite holding flap 28, which is arranged opposite with respect to the insertion direction 16 in substantially the same plane perpendicular to the insertion direction 16.

Although Fig. 2 shows three stacked pairs of holding flaps, this is not meant to limit the number and arrangement of the holding flaps 24, 26, 28 according to the invention. At least two flaps stacked above each other in the insertion direction 16 should, however, be provided at minimum.

A holding flap 24 may be spaced apart from its opposite holding flap 28 and/or from the subsequent holding flap 26 along the insertion direction 16. If, for example, the magnetic core 1 comprises the layers 18, at least one layer 18 may be arranged in the insertion direction 16 between subsequent, preferably overlapping holding flaps 24, 26.

If there are at least two pairs of holding flaps 24, 28 stacked upon each other as insertion direction 16, the spaces 30 between each holding flap 24, 26 of the pair may be aligned with each other to form a narrow opening 32 within the contact insertion hole 12. In particular, the center of the opening 32 which is defined by the pairs of holding flaps 24, 26 may be aligned with a centerline 34 of the contact insertion hole 12, wherein the centerline 34 is in particular parallel to the insertion direction 16.

At least one of the topmost or lowermost holding flaps may be spaced apart in the insertion direction 16 from an entry opening 36 or an exit opening 38 of the contact insertion hole 12.

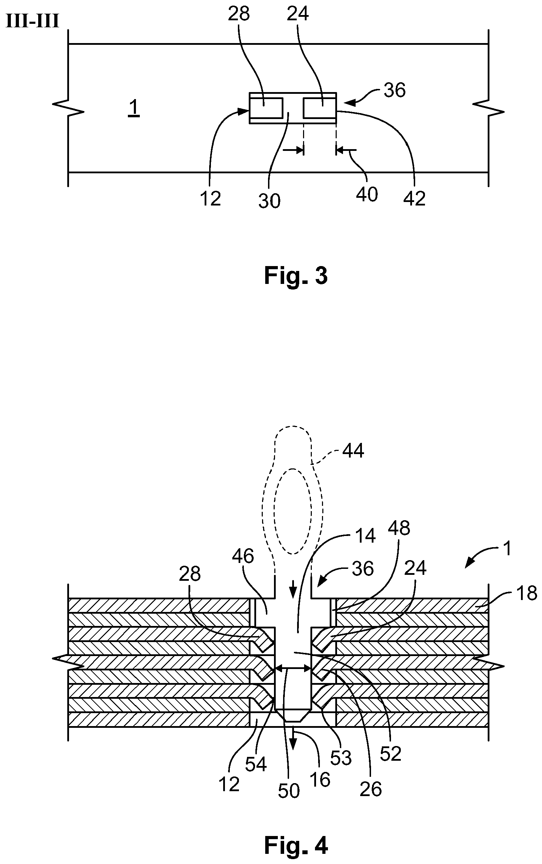

In the plan view of Fig. 3, it can be seen that the flaps 24, 28 can be perceived as protruding into the contact insertion hole 12. The length 40 of a holding flap 24, 26, 28, preferably of all holding flaps 24, 26, 28 is preferably larger than its material thickness. The material thickness of a holding flap may respond to the material thickness 20 of a layer 18 of the magnetic core 1. All flaps are preferably shaped identical.

In particular, it is preferred that a holding flap 24, 26, 28 is formed by a corresponding layer 18 simply extending flap-like into the contact insertion hole 12. Each flap 24, 26, 28 is preferably tongue-like and connected only at one side, its base 42, with layer 18. Three sides of the holding flap 24, 26, 28 may be spaced apart from the walls of the contact insertion hole 12 if the holding if the holding flap is rectangular. The length 40 may be polygonal, the base 42 forming one side of the polygon. Thus, each holding flap 24, 26, 28 corresponds to a leaf spring that may be elastically deflected when the plug contact 14 is inserted into the contact insertion hole 12. A distance between successive holding flaps 24, 26 in the insertion direction 16 allows a free bending movement without the risk of the holding flaps 24, 26 impeding one another.

In Fig. 4, the plug contact 14 is shown inserted into the contact insertion hole 12. An upper part 44 of the plug contact 14 is only shown in dashed phantom lines as its shape depends on the type of electric connector used to shortcut the plug contact 14.

A collar 46 of the plug contact 14 is inserted into an entry region 48 of the contact insertion hole 12, the entry region 48 being immediately adjacent to the entry opening 36 in the insertion direction 16. The collar 46 has a cross section perpendicular to the insertion direction 16, which cross section is complementary to the cross section of the entry region 48. Thus, the collar 46 fits snugly into the entry region 48, and thus centers and secures the plug contact 14 in a direction perpendicular to the insertion direction 16.

A width 50 of a plug section 52 of the plug contact 14, which plug section 52 is in contact with the at least two holding flaps 24, 26, is larger than a clear span of the contact insertion hole 12 in a direction perpendicular to the insertion direction 16. In the embodiment shown in Figs. 2 to 4, the clear span of the contact insertion hole 12 is defined by the distance between a pair of opposite holding flaps 24, 28. If the plug contact 14 is inserted into the contact insertion hole 12, the holding flaps 24, 26, 28 are elastically bent in the insertion direction 16. Thus, each holding flap presses against the plug contact 14, respectively its plug section 52. The free end 53 of each holding flap is inclined in the insertion direction, pointing away from the entry opening if the plug contact 14 is inserted.

Preferably, a holding flap 24, 26, 28, some, or all holding flaps comprise an edge 54, which is pressed against the plug contact 14, respectively its plug section 52 if the plug contact 14 is inserted into the contact insertion hole 12. This creates a high contact pressure which scrapes away any oxidized layers on the plug contact 14 and/or any insulating layer such as the insulation layer 22 on the holding flap or the plug contact 14.

Furthermore, the friction between the plug contact 14 and the magnetic core 1 is increased if the edge 54 is pressed into the plug contact 14. Thus, it is possible to guarantee a minimum holding or contact normal force.

If there is more than one contact insertion hole 12 in the magnetic core 1, as e.g. shown in Fig. 1, each layer 18 may form a holding flap in at least one of the contact insertion holes 12. Thus, each layer 18 is in direct contact with at least one plug contact 14.

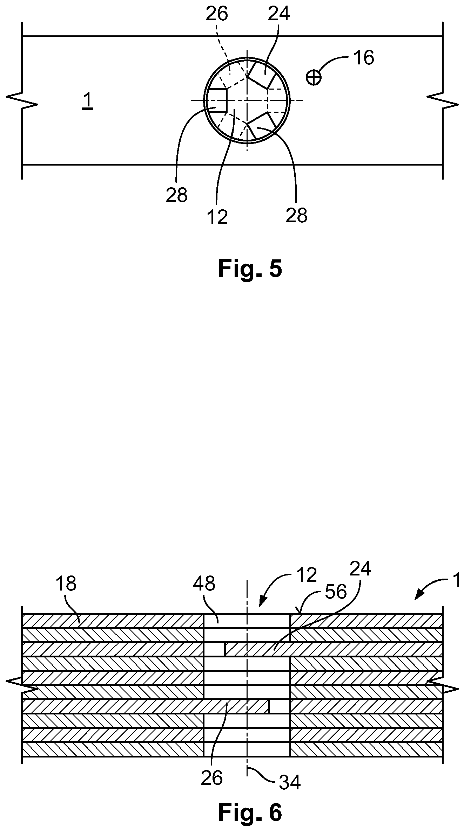

As shown in Fig. 5, the holding flaps 24, 26, 28 may also be used in a contact insertion hole 12 having a different cross section, such as a circular cross section. In such a case, there may be more than one opposite holding flap 28 in each plane that extends perpendicular to the extension direction. For example, by arranging three or more holding flaps 24 in such a plane about the circumference of the contact insertion hole 12, a holding flap 24 has two or more opposite holding flaps 28. This also creates a symmetric holding force which automatically centers the plug contact 14 when it is inserted into the contact insertion hole 12.

The at least one holding flap 26 which is stacked behind the holding flap 24 in the insertion direction 16, may be rotated out of overlap with the preceding holding flap 24, as is shown by the dashed lines in Fig. 5. This leads to a more even engagement of the plug contact 14 around its perimeter.

As shown in Fig. 6, there need not be an opposite holding flap 28 if the holding flaps 24, 26 are stacked asymmetrically with respect to the centerline 34 of the contact insertion hole 12. In such an asymmetric configuration of holding flaps, however, care should be taken that the plug contact 14 can be inserted in a centered manner. This can be achieved by either inserting the collar 46 into the entry region 48, or having a collar 46, which is larger than the contact insertion hole 12, rest on the surface 56 of the magnetic core 1.

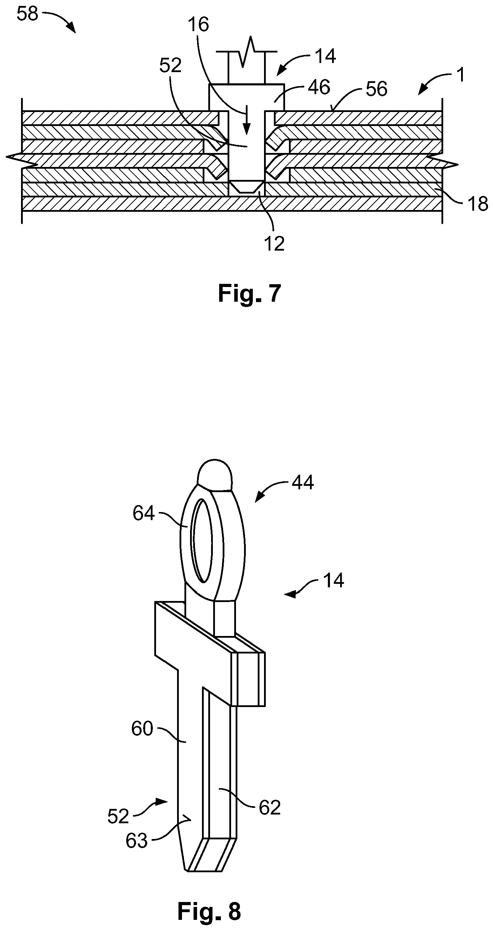

The contact insertion hole 12 may be a through opening or a blind hole. In Fig. 7, an example of a contact insertion hole 12 which is configured as a blind hole is shown. It is further shown that a centering function can also be achieved by a layer 18 which defines an opening which is complementary to the plug section 52 of the plug contact 14, and creates a form fit which is effectively perpendicular to the insertion direction 16. It is only for the purpose of explanation that the layer 18 having the centering function is at the bottom of the contact insertion hole 12.

It is important that the assembly 58 comprising the magnetic core 1 and the plug contact 14, guarantees a minimum contact normal force acting on the inserted plug contact 14 over the lifetime of the magnetic core 1.

Independent of the above-described configuration of the contact insertion hole 12 with the holding flaps 24, 26, 28, the plug contact 14 can also include features that lead to a constant contact normal force.

One such measure is to have a plug contact 14 which comprises a first electrically conductive material 60 and a second electrically conductive material 62, which is different from the first electrically conductive material 60. The first electrically conductive material 60 is located at least in the plug section 52 on an outside of the plug contact 14 such that it contacts the at least two holding flaps 24, 26 when inserted into the contact insertion hole 12.

To avoid deformation of the plug contact 14 by the deflected holding flaps 24, 26, 28 and thus a decrease of the contact normal force, the first electrically conductive material 60 is preferably harder than the second electrically conductive material 62.

Independent of the relative hardness of the material 60, 62, it may also be advantageous that the electric potential of the first electrically conductive material 60 is closer to the electric potential of the material of at least one of the holding flaps 24, 26, 28, preferably all holding flaps 24, 26, 28. This avoids contact corrosion between the holding flaps 24, 26, 28 and the plug contact 14.

The first electrically conductive material 60 may form an outer layer on the second electrically conductive material 62, in particular a surface 63 of the plug section 52. The layer may be a result of galvanization, electric coating or punch-plating of the second electrically conductive material 62. The second electrically conductive material 62 may form the core of the plug contact 14 and may be a material of particular low electric resistance such as copper, silver, or a material containing at least one of these materials. The first electrically conductive material 60 may be steel. The upper part 44 of the plug contact 14 forming the end opposite the plug section 52, may be made from a third electrically conductive material 64, such as tin or a material mix containing tin.

### REFERENCE NUMERALS

- 1: magnetic core
- 2: current sensor
- 4: electric conductor
- 6: central opening
- 8: magnetic sensor
- 10: magnetic air gap
- 12: contact insertion hole
- 14: plug contact
- 16: insertion direction
- 18: layer of magnetic core
- 20: material thickness of layer
- 22: electric insulation layer
- 24: holding flap
- 26: (stacked) holding flap
- 28: (opposite) holding flap
- 30: space between opposing flaps
- 32: opening
- 34: centerline of contact insertion hole
- 36: entry opening of contact insertion hole
- 38: exit opening of contact insertion hole
- 40: length of holding flap
- 42: base of holding flap
- 44: upper part of plug contact
- 46: collar
- 48: entry region of contact insertion hole
- 50: width
- 52: plug section of plug contact
- 53: free end of holding flap
- 54: edge of holding flap
- 56: surface of magnetic core
- 58: assembly
- 60: first electrically conductive material
- 62: second electrically conductive material
- 63: surface of plug section
- 64: third electrically conductive material

## Claims

1. Magnetic core (1) for conducting a magnetic field, the magnetic core (1) having at least one contact insertion hole (12) for inserting a plug contact (14), which penetrates the magnetic core (1) at least partially, the contact insertion hole (12) extending in an insertion direction (16) into the magnetic core (1) and comprising at least two holding flaps (24, 26) which are stacked with respect to the insertion direction (16) and extend substantially perpendicular to the insertion direction (16) of the plug contact (14).

2. Magnetic core (1) according to claim 1, wherein the magnetic core (1) comprises a plurality of layers (18) of magnetic sheet material, the contact insertion hole (12) penetrating at least some of the layers (18), and wherein each of the at least two holding flaps (24, 26) are part of a different layer (18).

3. Magnetic core (1) according to claim 2, wherein at least one layer (18) is arranged between two holding flaps (24, 26) which are located one behind the other in the insertion direction (16).

4. Magnetic core (1) according to claim 2 or 3, wherein the magnetic core (1) comprising more than one contact insertion hole (12) and wherein each layer (18) forms the flap in the at least one contact insertion hole (12).

5. Magnetic core (1) according to any one of claims 1 to 4, wherein the at least two holding flaps (24, 28) are comprised that are arranged opposite each other in a direction perpendicular to the insertion direction (16).

6. Magnetic core (1) according to claim 5, wherein the at least two opposing holding flaps (24, 28) are formed by the same layer (18).

7. Magnetic core (1) according to claim 5 or 6, wherein the opposing holding flaps (24, 28) are spaced apart from each in a direction perpendicular to the insertion direction (16).

8. Magnetic core (1) according to any one of claims 1 to 7, wherein the at least two holding flaps (24, 26) are arranged at a distance from an entry opening (36) of the contact insertion hole (12).

9. Magnetic core (1) according to any one of claims 1 to 8, wherein the magnetic core (1) has at least one of a C-shape, a U-shape and a ring shape, the ring shape being circumferentially closed except for a magnetic air gap (10).

10. Assembly (58) comprising a magnetic core (1) according to any one of claims 1 to 9, and the plug contact (14) for insertion into the contact insertion hole (12), the plug contact (14) comprising a first electrically conductive material (60) in at least a plug section (52) for insertion into the contact insertion hole (12) and second electrically conductive material (62), wherein the first electrically conductive material (60) forms an outer surface (63) of the plug section (52) and has a higher hardness than the second electrically conductive material (62).

11. Assembly (58) either according to claim 10, or comprising a magnetic core (1) according to any of claims 1 to 9 and the plug contact (14) for insertion into the contact insertion hole (12), the plug contact (14) further comprising a first electrically conductive material (60) in a plug section (52) for insertion into the contact insertion hole (12) and a second electrically conductive material (62), the first electrically conductive material (60) being adapted to have an electric potential which is closer to the electric potential of the material of at least one of the holding flaps (24, 26, 28) than the electric potential of the second electrically conductive material (62).

12. Assembly (58) according to claim 10 or 11, wherein the first electrically conductive material (60) forms a layer (18) on the second electrically conductive material (62).

13. Assembly (58) either according to any one of claims 10 to 12, or comprising a magnetic core (1) according to any one of claims 1 to 9 and the plug contact (14) being inserted into the contact insertion hole (12), and the at least two holding flaps (24, 26) comprising an edge (54), the edge (54) being pressed against the plug contact (14).

14. Assembly (58) according to any one of claims 10 to 13, and the holding flaps (24, 26) being elastically bent by the plug contact 14) being inserted into the contact insertion hole (12).

15. Assembly (58) either according to any one of claims 10 to 14, wherein the holding flaps (24, 26) comprise a free end (53), which is in contact with the plug contact (14) being inserted into the contact insertion hole (12).

## Patentansprüche

1. Magnetkern (1) zum Leiten eines Magnetfeldes, wobei der Magnetkern (1) wenigstens ein Kontakt-Einführloch (12) zum Einführen eines Steckkontaktes (14) aufweist, das den Magnetkern (1) wenigstens teilweise durchdringt, wobei sich das Kontakt-Einführloch (12) in einer Einführ-Richtung (16) in den Magnetkern (1) hinein erstreckt und wenigstens zwei Haltelaschen (24, 26) umfasst, die in Bezug auf die Einführ-Richtung (16) übereinander angeordnet sind und sich im Wesentlichen senkrecht zu der Einführ-Richtung (16) des Steckkontaktes (14) erstrecken.

2. Magnetkern (1) nach Anspruch 1, wobei der Magnetkern (1) eine Vielzahl von Schichten (18) aus magnetischem Blechmaterial umfasst, das Kontakt-Einführloch (12) wenigstens einige der Schichten (18) durchdringt und jede der wenigstens zwei Haltelaschen (24, 26) Teil einer anderen Schicht (18) ist.

3. Magnetkern (1) nach Anspruch 2, wobei wenigstens eine Schicht (18) zwischen zwei Haltelaschen (24, 26) angeordnet ist, die in der Einführ-Richtung (16) hintereinander liegen.

4. Magnetkern (1) nach Anspruch 2 oder 3, wobei der Magnetkern (1) mehr als ein Kontakt-Einführloch (12) umfasst und jede Schicht (18) die Lasche in dem wenigstens einen Kontakt-Einführloch (12) bildet.

5. Magnetkern (1) nach einem der Ansprüche 1 bis 4, wobei die wenigstens zwei Haltelaschen (24, 28) vorhanden sind, die in einer Richtung senkrecht zu der Einführ-Richtung (16) einander gegenüberliegend angeordnet sind.

6. Magnetkern (1) nach Anspruch 5, wobei die wenigstens zwei gegenüberliegenden Haltelaschen (24, 28) durch die gleiche Schicht (18) gebildet werden.

7. Magnetkern (1) nach Anspruch 5 oder 6, wobei die gegenüberliegenden Haltelaschen (24, 28) in einer Richtung senkrecht zu der Einführ-Richtung (16) voneinander beabstandet sind.

8. Magnetkern (1) nach einem der Ansprüche 1 bis 7, wobei die wenigstens zwei Haltelaschen (24, 26) in einem Abstand zu einer Eintrittsöffnung (36) des Kontakt-Einführlochs (12) angeordnet sind.

9. Magnetkern (1) nach einem der Ansprüche 1 bis 8, wobei der Magnetkern (1) eine C-Form, eine U-Form oder/und eine Ringform hat und die Ringform bis auf einen Magnet-Luftspalt (10) in Umfangsrichtung geschlossen ist.

10. Baugruppe (58), die einen Magnetkern (1) nach einem der Ansprüche 1 bis 9 sowie den Steckkontakt (14) zum Einführen in das Kontakt-Einführloch (12) umfasst, wobei der Steckkontakt (14) ein erstes elektrisch leitendes Material (60) in wenigstens einem Einsteck-Abschnitt (52) zum Einführen in das Kontakt-Einführloch (12) sowie ein zweites elektrisch leitendes Material (62) umfasst und das erste elektrisch leitende Material (60) eine Außenfläche (63) des Einsteck-Abschnitts (52) bildet und eine höhere Härte hat als das zweite elektrisch leitende Material (62).

11. Baugruppe (58) entweder nach Anspruch 10 oder umfassend einen Magnetkern (1) nach einem der Ansprüche 1 bis 9 sowie den Steckkontakt (14) zum Einführen in das Kontakt-Einführloch (12), wobei der Steckkontakt (14) des Weiteren ein erstes elektrisch leitendes Material (60) in einem Einsteck-Abschnitt (52) zum Einführen in das Kontakt-Einführloch (12) und ein zweites elektrisch leitendes Material (62) umfasst, das erste elektrisch leitende Material (60) so eingerichtet ist, dass es ein elektrisches Potential hat, das näher an dem elektrischen Potential des Materials wenigstens einer der Haltelaschen (24, 26, 28) liegt als das elektrische Potential des zweiten elektrisch leitenden Materials (62).

12. Baugruppe (58) nach Anspruch 10 oder 11, wobei das erste elektrisch leitende Material (60) eine Schicht (18) auf dem zweiten elektrisch leitenden Material (62) bildet.

13. Baugruppe (58) entweder nach einem der Ansprüche 10 bis 12 oder umfassend einen Magnetkern (1) nach einem der Ansprüche 1 bis 9, sowie den in das Kontakt-Einführloch (12) eingeführten Steckkontakt (14) und die wenigstens zwei Haltelaschen (24, 26), die eine Kante (54) umfassen, wobei die Kante (54) an den Steckkontakt (14) gedrückt wird.

14. Baugruppe (58) nach einem der Ansprüche 10 bis 13, und wobei die Haltelaschen (24, 26) elastisch gebogen werden, wenn der Steckkontakt (14) in das Kontakt-Einführloch (12) eingeführt wird.

15. Baugruppe (58) nach einem der Ansprüche 10 bis 14, wobei die Haltelaschen (24, 26) ein freies Ende (53) umfassen, das mit dem in das Kontakt-Einführloch (12) eingeführten Steckkontakt (14) in Kontakt ist.

## Revendications

1. Noyau magnétique (1) destiné à conduire un champ magnétique, le noyau magnétique (1) comportant au moins un trou d'insertion de contact (12) pour insérer un contact à enficher (14), qui pénètre au moins partiellement dans le noyau magnétique (1), le trou d'insertion de contact (12) s'étendant en direction d'insertion (16) dans le noyau magnétique (1) et comprenant au moins deux pattes de maintien (24, 26) qui sont empilées par rapport à la direction d'insertion (16) et s'étendent de manière substantiellement perpendiculaire à la direction d'insertion (16) du contact à enficher (14).

2. Noyau magnétique (1) selon la revendication 1, dans lequel le noyau magnétique (1) comprend une pluralité de couches (18) d'un matériau de feuille magnétique, le trou d'insertion de contact (12) pénétrant au moins certaines des couches (18), et dans lequel chacune desdites au moins deux pattes de maintien (24, 26) fait partie d'une couche différente (18).

3. Noyau magnétique (1) selon la revendication 2, dans lequel au moins une couche (18) est agencée entre deux pattes de maintien (24, 26) qui sont placées l'une derrière l'autre en direction d'insertion (16).

4. Noyau magnétique (1) selon la revendication 2 ou 3, dans lequel le noyau magnétique (1) comprend plus d'un trou d'insertion de contact (12) et dans lequel chaque couche (18) forme la patte dans ledit au moins un trou d'insertion de contact (12).

5. Noyau magnétique (1) selon l'une quelconque des revendications 1 à 4, dans lequel sont comprises lesdites au moins deux pattes de maintien (24, 28) qui sont agencées de manière opposée entre elles dans une direction perpendiculaire à la direction d'insertion (16).

6. Noyau magnétique (1) selon la revendication 5, dans lequel lesdites au moins deux pattes de maintien opposées (24, 28) sont formées par la même couche (18).

7. Noyau magnétique (1) selon la revendication 5 ou 6, dans lequel les pattes de maintien opposées (24, 28) sont espacées entre elles dans une direction perpendiculaire à la direction d'insertion (16).

8. Noyau magnétique (1) selon l'une quelconque des revendications 1 à 7, dans lequel lesdites au moins deux pattes de maintien (24, 26) sont agencées à une certaine distance d'une ouverture d'entrée (36) du trou d'insertion de contact (12).

9. Noyau magnétique (1) selon l'une quelconque des revendications 1 à 8, dans lequel le noyau magnétique (1) présente au moins une forme parmi une forme en C, une forme en U et une forme annulaire, la forme annulaire étant fermée circonférentiellement, sauf un entrefer magnétique (10) .

10. Ensemble (58) comprenant un noyau magnétique (1) selon l'une quelconque des revendications 1 à 9 et le contact à enficher (14) à insérer dans le trou d'insertion de contact (12), le contact à enficher (14) comprenant un premier matériau électroconducteur (60) dans au moins une section de fiche (52) à insérer dans le trou d'insertion de contact (12) et un deuxième matériau électroconducteur (62), dans lequel le premier matériau électroconducteur (60) forme une surface externe (63) de la section de fiche (52) et présente une dureté plus élevée que le deuxième matériau électroconducteur (62).

11. Ensemble (58) soit selon la revendication 10, soit comprenant un noyau magnétique (1) selon l'une quelconque des revendications 1 à 9 et le contact à enficher (14) à insérer dans le trou d'insertion de contact (12), le contact à enficher (14) comprenant en outre un premier matériau électroconducteur (60) dans une section de fiche (52) à insérer dans le trou d'insertion de contact (12) et un deuxième matériau électroconducteur (62), le premier matériau électroconducteur (60) étant adapté pour présenter un potentiel électrique plus proche du potentiel électrique du matériau d'au moins une des pattes de maintien (24, 26, 28) que le potentiel électrique du deuxième matériau électroconducteur (62).

12. Ensemble (58) selon la revendication 10 ou 11, dans lequel le premier matériau électroconducteur (60) forme une couche (18) sur le deuxième matériau électroconducteur (62) .

13. Ensemble (58) soit selon l'une quelconque des revendications 10 à 12, soit comprenant un noyau magnétique (1) selon l'une quelconque des revendications 1 à 9, le contact à enficher (14) étant inséré dans le trou d'insertion de contact (12), lesdites au moins deux pattes de maintien (24, 26) comprenant un bord (54), le bord (54) étant poussé contre le contact à enficher (14).

14. Ensemble (58) selon l'une quelconque des revendications 10 à 13, les pattes de maintien (24, 26) étant fléchies élastiquement par le contact à enficher (14) inséré dans le trou d'insertion de contact (12).

15. Ensemble (58) selon l'une quelconque des revendications 10 à 14, dans lequel les pattes de maintien (24, 26) comprennent une extrémité libre (53), qui est en contact avec le contact à enficher (14) inséré dans le trou d'insertion de contact (12).
